# EUROPÄISCHE PATENTSCHRIFT

(11) **EP 1 257 438 B1**
(45) Veröffentlichungstag und Bekanntmachung des Hinweises auf die Patenterteilung: **12.10.2005**
(21) Anmeldenummer: 01919151.9
(22) Anmeldetag: 26.02.2001
(51) Int. Cl.: B60R 16/02

(54) **EINRICHTUNG ZUR ÜBERTRAGUNG ELEKTRISCHEN STROMS ZWISCHEN ZWEI ZUEINANDER VERDREHBAREN BAUELEMENTEN EINER LENKEINRICHTUNG FÜR KRAFTFAHRZEUGE**
DEVICE FOR TRANSMITTING ELECTRIC CURRENT BETWEEN TWO COMPONENTS, WHICH TWIST IN RELATION TO ONE ANOTHER, OF A STEERING DEVICE FOR MOTOR VEHICLES
DISPOSITIF POUR TRANSMETTRE UN COURANT ELECTRIQUE ENTRE DEUX ELEMENTS A TORSION MUTUELLE D'UN MECANISME DE DIRECTION POUR AUTOMOBILES

(30) Priorität: 24.02.2000 DE 20003965 U
(43) Veröffentlichungstag der Anmeldung: 20.11.2002
(73) Patentinhaber: Takata-Petri AG, 63743 Aschaffenburg (DE)
(72) Erfinder: BONN, Helmut, 63808 Haibach (DE)
(74) Vertreter: Baumgärtel, Gunnar
(86) Internationale Anmeldenummer: PCT/DE2001/000776
(87) Internationale Veröffentlichungsnummer: WO 2001/062551

(56) Entgegenhaltungen:
- EP-A- 0 482 937
- EP-A- 0 775 611
- EP-A- 0 913 319
- DE-A- 4 004 233
- DE-A- 4 027 952
- DE-A- 19 649 906
- US-A- 4 149 026
- US-A- 4 367 585

## Beschreibung

Die Erfindung betrifft eine Einrichtung zur Übertragung elektrischen Stroms zwischen zwei zueinander verdrehbaren Bauelementen einer Lenkeinrichtung für Kraftfahrzeuge entsprechend dem Oberbegriff des Anspruchs 1, wie sie aus der DE 40 27 952 A1 bekannt ist.

Solche Einrichtungen dienen der Übertragung elektrischen Stroms (insbesondere von Signal- und/oder Leistungsstrom) von der karosseriefest angeordneten Bordelektronik eines Kraftfahrzeugs auf das Lenkrad oder umgekehrt. Hierdurch können am Lenkrad vorgesehene elektrische oder elektronische Funktionselemente, wie z.B. die Zündung des Gasgenerators einer Airbageinheit, eine Lenkradbeheizung oder elektrische Schalter zum Betätigen von Blinkern, Scheibenwischern oder eines Radios in das Lenkrad integriert und von der Bordelektronik her mit Strom versorgt werden.

Eine Einrichtung zur Übertragung elektrischen Stroms ist ferner aus der DE 41 11 699 bekannt. Diese umfaßt einen Rotor, der dem Lenkrad zugeordnet und gemeinsam mit diesem drehbar ist, sowie einen Stator, der einer bezüglich der Drehbewegung des Lenkrads ortsfesten Baugruppe, wie z.B. der Lenksäulenverkleidung der Lenkeinrichtung zugeordnet ist. Der Rotor und der Stator sind durch einen flexiblen elektrischen Leiter miteinander verbunden, der als bandähnlicher gedruckter Schaltkreis ausgeführt ist. Dieser flexible elektrische Leiter wird je nach Drehrichtung des Rotors auf einer zwischen Rotor und Stator ausgebildeten Zwischenplatte auf bzw. abgerollt.

Bei der bekannten Einrichtung ist die Anzahl einzelner Leiterbahnen des gedruckten Schaltkreises auf dem flexiblen Leiter durch dessen Ausmaße begrenzt. Werden mehr Leiterbahnen benötigt, so muß entweder ein größerer flexibler Leiter oder eine Mehrzahl von Leitern eingesetzt werden. Dies führt in beiden Fällen zu einem erhöhten Platzbedarf des flexiblen Leiters in der Vorrichtung.

Der Erfindung liegt die Aufgabe zugrunde, eine Einrichtung zur Übertragung elektrischen Stroms der eingangs genannten Art zu schaffen, die bei geringem Platzbedarf eine möglichst große Zahl an Leiterbahnen für die Stromübertragung zur Verfügung stellt.

Diese Aufgabe wird erfindungsgemäß durch die Schaffung einer Vorrichtung zur Übertragung elektrischen Stroms zwischen zwei zueinander verdrehbaren Bauelementen (Stator und Rotor) einer Lenkeinrichtung für Kraftfahrzeuge mit den Merkmalen des Patentanspruchs 1 gelöst.

Danach ist der vom Stator zum Rotor verlaufende flexible Leiter als flexible Leiterplatte ausgebildet. Diese ist bei Drehung des Lenkrades auf ein Wickelelement auf- bzw. abwickelbar und umfaßt einen flach ausgebildeten flexiblen Träger, auf dessen Vorder- und Rückseite Leiterbahnen vom Stator zum Rotor verlaufen.

Als flexiblen Träger umfaßt eine solche flexible Leiterplatte beispielsweise eine beidseitig mit einer Mehrzahl von metallischen Leiterbahnen versehene elektrisch isolierende Trägerfolie, wobei die Leiterbahnen durch Isolatorfolien abgedeckt sind.

Zur Herstellung des gewünschten Leiterbahndesigns werden dabei nicht benötigten Bereiche der Metalldünnschichten auf Vorder- und Rückseite der flexiblen Trägerfolie beispielsweise durch Photolithographie- und Ätztechnik entfernt, so daß die gewünschten vereinzelten Leiterbahnen entstehen.

Die beidseitige Nutzung mindestens einer Trägerfolie als flexible Leiterplatte ermöglicht daher auf einfache Weise eine Verdopplung der Fläche, auf der das gewünschte Schaltungs- und Leiterbahndesign aufgebracht werden kann.

Die flexible Leiterplatte übernimmt zudem zusätzlich zur Stromübertragung noch weitere Funktionen, indem weitere elektrische oder elektronische Bauelemente in die Leiterplatte integriert werden. Dabei wird sowohl die Anzahl separater elektrischer bzw. elektronischer Bauelemente im Bereich der Lenkeinrichtung als auch deren Platzbedarf reduziert. Damit kann eine einzelne Leiterplatte neben der Übermittlung elektrischer Signale vom Stator zum Rotor noch eine Vielzahl zusätzlicher Funktionen erfüllen.

Der flexiblen Leiterplatte sind an dem Stator und dem Rotor jeweils mindestens ein elektrischer Anschluß zugeordnet, wobei die flexible Leiterplatte an ihrem stator- und ihrem rotorseitigen Ende elektrische Kontaktelemente aufweist, die mit diesen Anschlüssen in elektrischen Kontakt bringbar sind. Die genannten Kontaktelemente sind vorzugsweise als Steckerelemente ausgebildet, die in die entsprechenden elektrischen Anschlüsse des Stators bzw. des Rotors einsteckbar und durch elektrische Leitungen mit den Leiterbahnen des flexiblen Trägers verbunden sind.

Die Kontaktelemente der flexiblen Leiterplatte können dabei sowohl zur Kontaktierung von im wesentlichen quer zur Erstreckungsrichtung der flexiblen Leiterplatte angeordneten elektrischen Anschlüssen als auch zur Kontaktierung von im wesentlichen parallel zur flexiblen Leiterplatte angeordneten elektrischen Anschlüssen vorgesehen sein.

Werden eine Vielzahl von Leiterbahnen zwischen Stator und Rotor benötigt, so ist es von Vorteil, die durch beidseitiges Bedrucken der flexiblen Trägerfolie mit einer Metallschicht und anschließendes selektives Ätzen hergestellten Leiterbahnen derart auszubilden, daß der Abstand zwischen den einzelnen Leiterbahnen im Bereich des rotor- und/oder des statorseitigen Endes der Leiterplatte im Vergleich zum mittleren Abschnitt der Leiterplatte zunimmt. Hierdurch kann der mittlere Abschnitt der flexiblen Leiterplatte, der beim Drehen des Lenkrades auf- bzw. abgewickelt wird, besonders schmal ausgeführt sein. An ihren beiden Enden verbreitert sich dann die flexible Leiterplatte, so daß dort die einzelnen Leiterbahnen mit einem größeren Abstand nebeneinander angeordnet sein können und die elektrische Kontaktierung der einzelnen Leiterbahnen entsprechend erleichtert wird.

Weiterhin ist es vorteilhaft, wenn die flexible Leiterplatte an ihrem stator- und/oder rotorseitigen Ende, insbesondere im Bereich ihrer elektrischen Kontaktelemente, zur Stabilisierung Verstärkungselemente aufweist. Diese können insbesondere durch Kunststoffelemente gebildet werden, die auf die flexible Leiterplatte aufgespritzt oder aufgeclipst sind. Als Verstärkungselemente eignen sich vor allem FR4-Platinen, die den vorzugsweise aus Polyester oder Polyimid bestehenden flexiblen Träger der Leiterplatte gezielt abstützen.

Die flexible Leiterplatte weist vorzugsweise Mittel auf, die die Zugentlastung der elektrischen Kontaktierungen zwischen den elektrischen Leitungen und den Leiterbahnen auf der flexiblen Trägerfolie der Leiterplatte gewährleisten. Beispielsweise können die Verstärkungen einen Aufnahmeabschnitt aufweisen, der eine Mehrzahl von Führungsaussparungen umfaßt, in die sich die elektrischen Leitungen einpassen und kraftschlüssig mit den Verstärkungselementen verbinden lassen.

Um die Montage der genannten elektrischen Kontaktierung zu erleichtern, ist es von Vorteil, wenn die Verstärkungselemente aus mindestens zwei plättchenförmigen im wesentlichen gleichgroßen Einzelelementen bestehen, die sich derart zusammenfügen lassen, daß die flexible Leiterplatte und die zugeführten elektrischen Leitungen umschlossen werden.

An den Fügekanten können die Einzelelemente mit Hilfe von Filmscharnieren aneinander befestigt werden, so daß sich die flexible Leiterplatte und die elektrischen Kontaktelemente in einfacher Weise mittels eines Klappmechanismus durch die Einzelelemente umschließen lassen.

Die flexible Leiterplatte kann an ihren Enden einerseits über Rastelemente mit dem Stator bzw. dem Rotor verbunden sein und andererseits auf den Stator bzw. den Rotor aufgeklebt werden. Die Verbindung erfolgt dabei vorteilhaft über die genannten Verstärkungselemente.

Eine weitere vorteilhafte Ausführungsform weist ein breiter ausgebildetes rotor- bzw. statorseitiges Ende der flexiblen Leiterplatte auf, wobei die auf Vorder- und Rückseite der flexiblen Leiterplatte verlaufenden Leiterbahnen in nebeneinander auf der flexiblen Leiterplatte angeordneten Bereichen enden. An diese Leiterbahnenden können daher jeweils elektrische Kontaktelemente angeschlagen werden, ohne daß bei der Kontaktierung die Gefahr eines Kurzschlusses zwischen Leiterbahnen auf Vorder- und Rückseite des flexiblen Leiters besteht. Das rotor- bzw. statorseitige Ende der flexiblen Leiterplatte läßt sich derart falten, daß die elektrischen Kontaktelemente der Leiterbahnen quer zur Erstreckungsrichtung der Leiterplatte nebeneinander zum Liegen kommen und somit ein kompaktes elektrisches Kontaktelement bilden.

Eine Stabilisierung der flexiblen Leiterplatte kann auch dadurch erreicht werden, daß diese zumindest abschnittsweise mit einer Ummantelung aus Kunststoff versehen ist.

Ein weiterer wesentlicher Vorteil der erfindungsgemäßen Lösung liegt darin, daß in die flexible Leiterplatte, insbesondere an einem ihrer Enden, weitere elektronische Baugruppen integriert werden können.

So kann am statorseitigen Ende der flexiblen Leiterplatte ein Lenkwinkelsensor vorgesehen sein, dessen elektronische Auswerteinheit in die flexible Leiterplatte integriert ist. In das rotorseitige Ende der flexiblen Leiterplatte kann eine Elektronikeinheit integriert sein, die mit lenkradseitigen elektrischen Bauelementen, wie z.B. einer Zündvorrichtung für einen Airbag oder mit am Lenkrad angeordneten Multifunktionsschaltern gekoppelt ist.

Wenn das Lenkrad eine Beheizung vorsieht, so kann die Steuerungselektronik der Lenkradbeheizung vorzugsweise in der flexiblen Leiterplatte integriert werden.

Durch die flexible Leiterplatte lassen sich auch codierte Signale übertragen, wobei die Codierung und/oder Decodierung der Signale mittels integrierter Schaltkreise auf der Leiterplatte selbst erfolgt.

Hinsichtlich der geometrischen Ausbildung der erfindungsgemäßen Einrichtung ist es vorteilhaft, daß der Stator und der Rotor ein inneres und ein äußeres Gehäuseelement bilden, von denen das eine das andere ringartig umgibt und die gegeneinander verdrehbar sind, wobei vorzugsweise der Stator den Rotor umgibt. Das zur Aufnahme der flexiblen Leiterplatte vorgesehene Wickelelement ist entweder als Bestandteil des Rotors oder als frei drehbares Wickelsegment ausgebildet. Dadurch wird zwischen dem Stator und dem Rotor eine Aufnahme für die flexible Leiterplatte gebildet.

In einer bevorzugten Ausführungsform weist die flexible Leiterplatte mindestens einen Abschnitt auf, an dem sich die Erstreckungsrichtung der flexiblen Leiterplatte bezüglich des Umfangs der Anordnung umkehrt. D.h. von einem Ende (z.B. dem statorseitigen Ende) der flexiblen Leiterplatte ausgehend verläuft die flexible Leiterplatte zunächst entlang einer ersten Umfangsrichtung (also im Uhrzeigersinn oder entgegen dem Uhrzeigersinn, je nach Art der Wicklung) bis zu dem besagten Abschnitt, an dem sich dann deren Erstreckungsrichtung (bezogen auf den Uhrzeigersinn) umkehrt.

Der besagte Abschnitt der flexiblen Leiterplatte ist dabei im wesentlichen U-förmig, und die flexible Leiterplatte wird zwischen dem Stator und dem Rotor mittels eines Führungsringes geführt, der den U-förmigen Abschnitt der flexiblen Leiterplatte abstützt. Durch den Führungsring werden zwischen dem Stator und dem Rotor eine Aufnahme für den auf dem Wickelelement aufgewickelten Teil der flexiblen Leiterplatte und eine weitere Aufnahme für den von dem Wickelelement abgewickelten Teil der flexiblen Leiterplatte gebildet.

Wenn das Wickelelement der Einrichtung als bewegliches Wickelsegment ausgeführt ist, ist es weiterhin möglich, daß das Wickelsegment eine Mehrzahl U-förmiger Durchgänge aufweist, so daß mehrere flexible Leiterplatten hintereinander auf- und abgewickelt werden können.

Eine solche Anordnung von Stator, Rotor und den zugehörigen elektrischen Leitern ist vom Prinzip her in der EP 0 556 779 A1, der DE 195 06 865 C1 und der DE 197 34 527 A1 beschrieben, auf die hier Bezug genommen wird. Diese Ausführungsformen der Erfindung haben den Vorteil, daß für die Drehung des Lenkrades und damit des Rotors eine vergleichsweise geringe Länge der flexiblen Leiterplatte erforderlich ist.

Eine weitere vorteilhafte Ausführungsform der Erfindung ist dadurch charakterisiert, daß der Stator zur Aufnahme eines Bedienschalters, wie z.B. eines Blinkerschalters, vorgesehen ist, dem eine elektronische Baugruppe auf der flexiblen Leiterplatte zugeordnet ist. Der Bedienschalter kann dabei insbesondere in eine hierfür vorgesehene Aufnahme des Stators einsteckbar sein. Die Leiterplatte bildet dann nicht nur eine elektronische Steuereinheit für Bauelemente, die über die flexible Leiterplatte mit Strom versorgt werden, sondern auch für solche elektrischen Bauelemente, wie z.B. einen Blinkerschalter, die am Stator vorgesehen sind und über separate Zuleitungen von der Bordelektronik her mit Strom versorgt werden.

Weitere Vorteile der Erfindung werden bei der nachfolgenden Beschreibung von Ausführungsbeispielen anhand der Zeichnungen deutlich werden.

Es zeigen:
- Fig. 1a -: einen Querschnitt einer Einrichtung zur Übertragung elektrischen Stroms zwischen zwei zueinander verdrehbaren Bauelementen einer Lenkeinrichtung für Kraftfahrzeuge mit einem Stator und einem Rotor, die über eine flexible Leiterplatte miteinander verbunden sind;
- Fig. 1b -: eine Draufsicht auf einen Abschnitt des Stators aus Fig. 1a;
- Fig. 1c -: einen Querschnitt im mittleren Bereich einer flexiblen Leiterplatte zur Übertragung elektrischen Stroms zwischen zwei zueinander verdrehbaren Bauelementen einer Lenkeinrichtung für Kraftfahrzeuge, die in einer Einrichtung gemäß Fig. 1a eingesetzt wird;
- Fig. 2a -: eine Draufsicht auf eine weitere Ausführungsform einer Einrichtung zur Übertragung elektrischen Stroms gemäß Fig. 1a;
- Fig. 2b -: eine Teilansicht der Einrichtung gemäß der Orientierung IIb in Fig. 2a;
- Fig. 2c -: einen Schnitt durch die Einrichtung entlang der Linie IIc-IIc in Fig. 2a;
- Fig. 3a -: eine Draufsicht auf eine Ausführungsform der flexiblen Leiterplatte aus Fig. 1a;
- Fig. 3b -: eine Draufsicht auf eine zweite Ausführungsform der flexiblen Leiterplatte aus Fig. 1a;
- Fig. 3c -: einen Schnitt durch die flexible Leiterplatte gemäß Fig. 3b im Bereich ihres rotorseitigen Verstärkungselementes;
- Fig. 3d -: eine Draufsicht auf drei Einzelkomponenten des rotorseitigen Verstärkungselements gemäß Figuren 3b und 3c;
- Fig. 4a -: eine Draufsicht auf eine dritte Ausführungsform der flexiblen Leiterplatte aus Fig. 1a;
- Fig. 4b -: einen Schnitt durch die flexible Leiterplatte entlang der Linie IVb-IVb gemäß Fig. 4a im Bereich des statorseitigen Endes;
- Fig. 5a -: eine Draufsicht auf eine vierte Ausführungsform der flexiblen Leiterplatte aus Fig. 1a;
- Fig. 5b -: einen vergrößerten Schnitt durch die flexible Leiterplatte entlang der Line Vb-Vb gemäß Fig. 5a;
- Fig. 6 -: eine Draufsicht auf eine fünfte Ausführungsform der flexiblen Leiterplatte aus Fig. 1a;
- Fig. 7 -: eine Draufsicht auf eine sechste Ausführungsform der flexiblen Leiterplatte aus Fig. 1a.

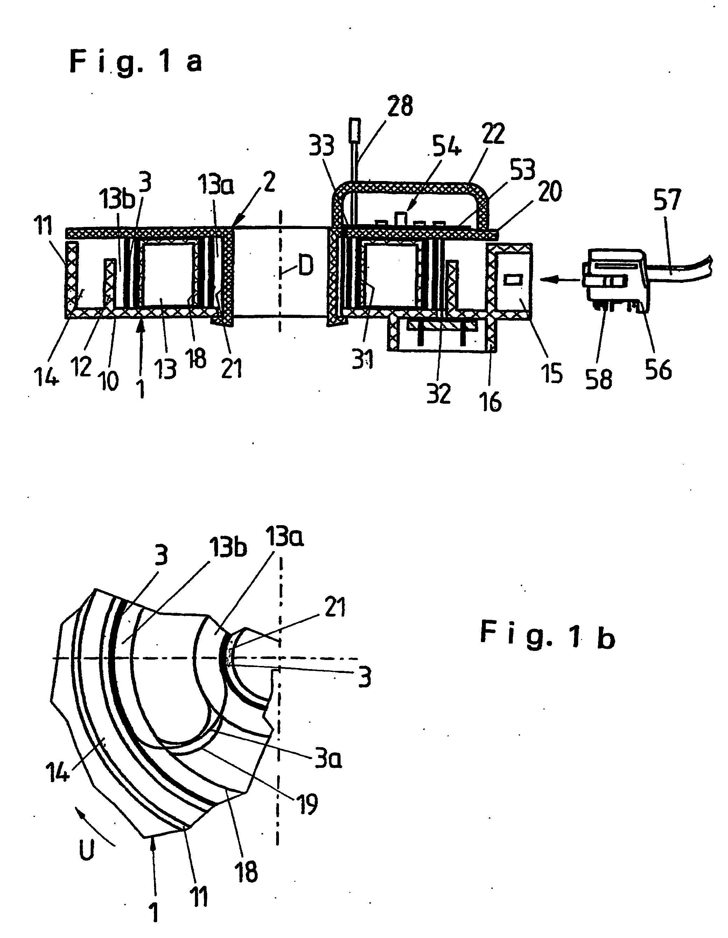

Fig. 1a zeigt einen Querschnitt durch eine Einrichtung zur Übertragung elektrischen Stroms zwischen zwei zueinander verdrehbaren Bauelementen einer Lenkeinrichtung für Kraftfahrzeuge mit einem Stator 1, der einer stationären Baugruppe des Fahrzeugs zugeordnet ist und insbesondere auf einer stationären Lenksäulenverkleidung der Lenkeinrichtung befestigt sein kann und mit einem Rotor 2, der dem Lenkrad zugeordnet und gemeinsam mit diesem um die Drehachse D drehbar ist. Zusätzlich ist in Fig. 1b eine Draufsicht auf einen Abschnitt des Stators 1 dargestellt.

Der rotationssymmetrisch bezüglich der Drehachse D ausgebildete Stator 1 umfaßt eine Basisfläche 10, die sich senkrecht zu der Drehachse D erstreckt und von der eine Außenwand 11, eine von der Außenwand 11 radial nach innen abgesetzte Zwischenwand 12 und ein noch weiter nach innen abgesetzter, im Querschnitt rechteckiger Führungsring 18 abstehen. Die Außenwand 11 weist in einem Abschnitt eine Aufnahme 15 für einen Blinkerschalter 56 auf, der über einen Betätigungshebel 57 auslösbar ist und über ein elektrisches Steckerelement 58 mit den Blinkern des Kraftfahrzeugs verbunden werden kann.

Der Stator 1 bildet mit seiner Basisfläche 10 und seiner Außenwand 11 ein Gehäuse, das den Rotor 2 ringartig umgibt. Der Rotor 2 umfaßt ebenfalls eine senkrecht zu der Drehachse D verlaufende Basisfläche 20, die der Basisfläche 10 des Stators 1 gegenüberliegt und von der senkrecht eine Wickelfläche 21 für eine flexible Leiterplatte 3 absteht. Die Basisfläche 20 des Rotors 2 weist in einem Abschnitt einen Deckel 22 auf, der ein Gehäuse bildet.

Zwischen der Basisfläche 10 und der Zwischenwand 12 des Stators 1 einerseits und der Basisfläche 20 sowie der Wickelfläche 21 des Rotors 2 andererseits ist eine Kammer 13 ausgebildet, die zur Aufnahme des mittleren Abschnitts 31 einer flexiblen Leiterplatte 3 dient, die sich von dem Stator 1 zu dem Rotor 2 erstreckt. An diese Kammer 13 schließt sich jenseits der Zwischenwand 12 radial nach außen eine weitere Kammer 14 an, die der Aufnahme von Baugruppen zur Bestimmung des Drehwinkels des Rotors 2 bezüglich des Stators 1 dient.

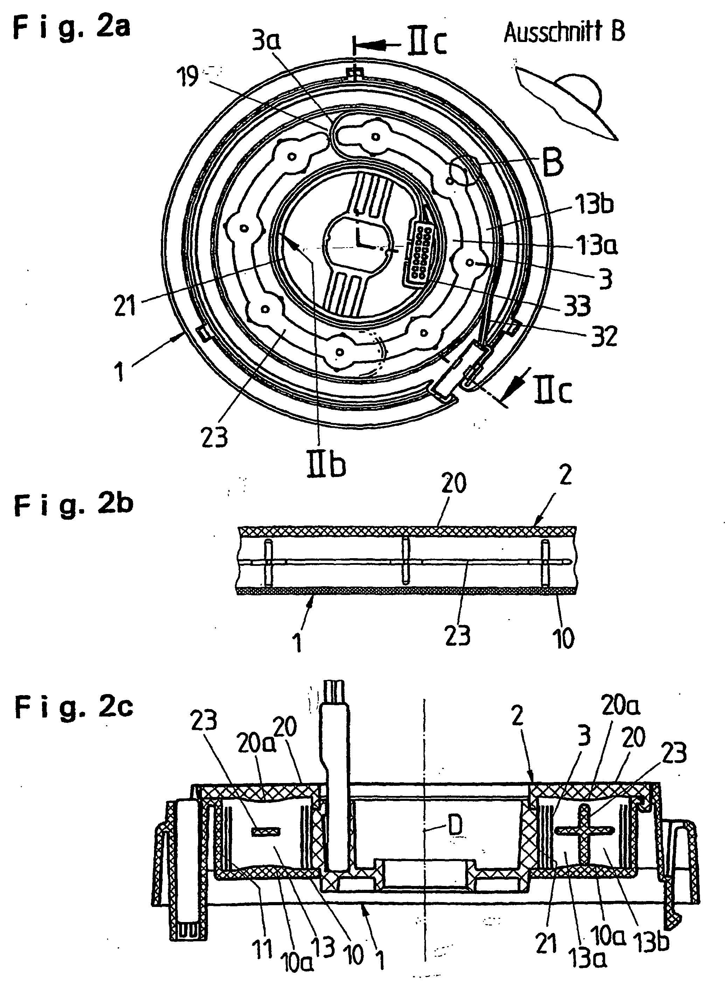

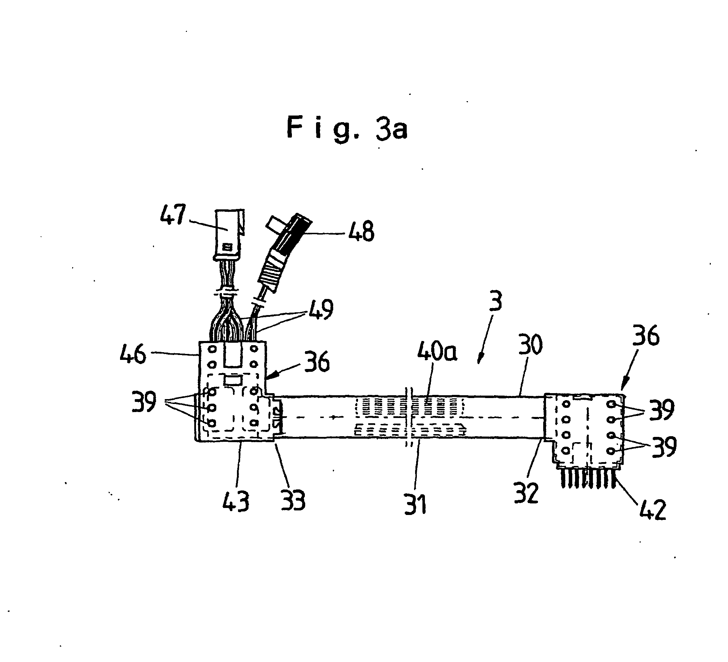

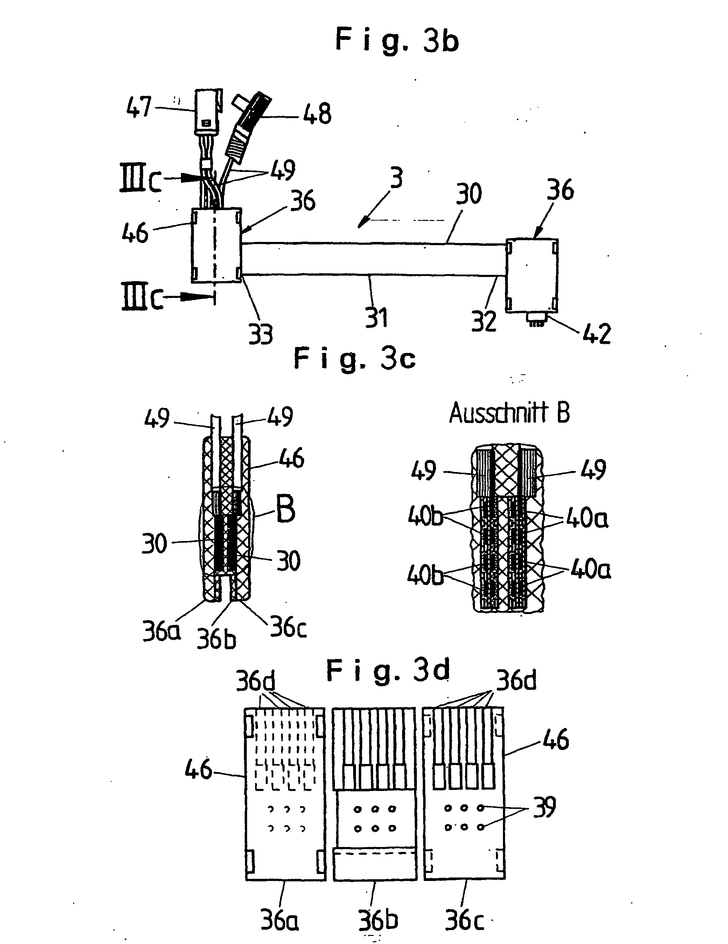

Das statorseitige Ende 32 der Leiterplatte 3 ist als Stekkerelement ausgebildet (vergl. Figuren 2a - 4) und in einer Steckeraufnahme 16 des Stators 1 angeordnet. Das rotorseitige Ende 33 der flexiblen Leiterplatte 3 ist ebenfalls als Steckerelement ausgebildet (vergl. Figuren 2a - 4) und unter dem Deckel 22 des Rotors 2 vorgesehen. An dem rotorseitigen Ende 33 der flexiblen Leiterplatte 3 ist in Fig. 1a noch ein Fortsatz 53 erkennbar, der mehrere elektrische Bauelemente einer elektronischen Steuereinheit 54 aufweist. Näheres hierzu wird nachfolgend anhand der Fig. 3 erläutert werden.

Die flexible Leiterplatte 3 dient der Übertragung elektrischen Stroms (also sowohl der Übertragung von Signalstrom als auch der Übertragung von Leistungsstrom) von dem Stator 1 zu dem Rotor 2 oder umgekehrt. Hierdurch können an einem Lenkrad vorgesehene elektrische Baugruppen, wie z.B. die Zündvorrichtung des Gasgenerators einer Airbageinheit oder Multifunktionsschalter zur Betätigung elektrischer Funktionseinheiten des Kraftfahrzeugs über den Rotor 2, die flexible Leiterplatte 3 und den Stator 1 mit der stationär angeordneten Bordelektronik des Fahrzeugs verbunden werden.

Die Verwendung eines Stators, eines Rotors und einer flexiblen Leitung zur Übertragung elektrischer Signale zwischen zwei zueinander verdrehbaren Baugruppen einer Lenkeinrichtung für Kraftfahrzeuge ist grundsätzlich bekannt. Für weitere Einzelheiten hierzu sei deshalb beispielhaft auf die DE 41 11 699 und DE 195 25 928 C2 verwiesen.

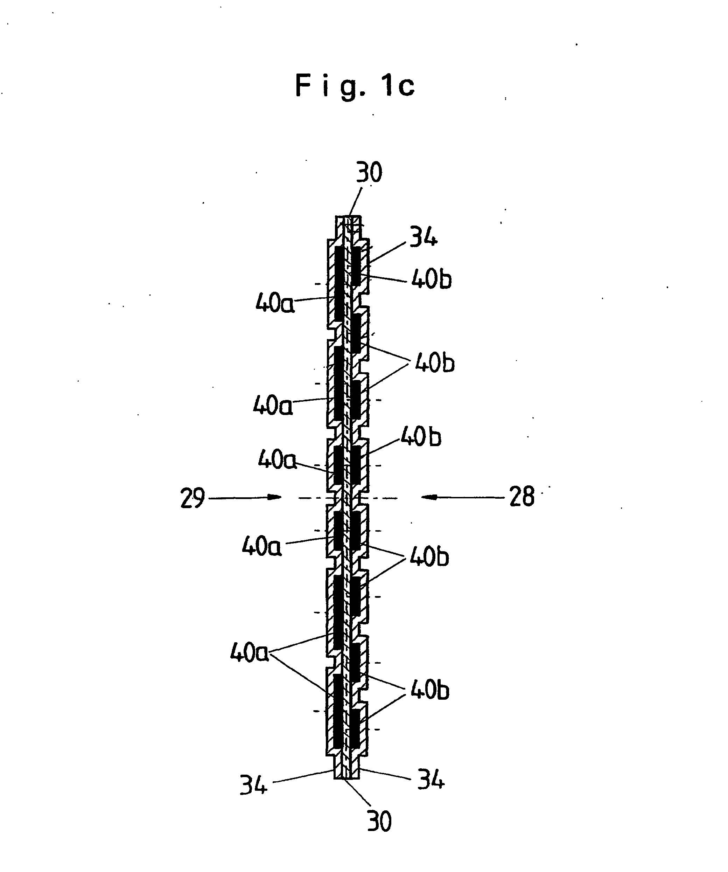

Fig. 1c zeigt einen Querschnitt durch den mittleren Bereich einer flexiblen Leiterplatte 3 zur Übertragung von Signal- und/oder Leistungsstrom zwischen zwei zueinander verdrehbaren Bauelementen einer Lenkeinrichtung von Kraftfahrzeugen. Es ist erkennbar, daß die flexible Leiterplatte 3 längs der Erstreckungsrichtung zwischen stator- und rotorseitigem Ende schichtartig aufgebaut ist, wobei die mittlere Schicht durch eine flexible Trägerfolie 30 ausgebildet ist, die beidseitig aus Metalldünnschichten bestehende Leiterbahnen 40a,40b aufweist, die jeweils durch eine Isolatorfolie 34 abgedeckt sind.

Es ist ferner erkennbar, daß die Querschnitte der Leiterbahnen 40a,40b je nach erforderlicher Stromstärke unterschiedlich groß ausgebildet sind.

Die vorliegende Erfindung zeichnet sich gegenüber den bekannten Einrichtungen zur Übertragung elektrischen Stroms der genannten Art dadurch aus, daß zur Verbindung von Stator 1 und Rotor 2 eine flexible Leiterplatte 3 verwendet wird, die einen flach ausgebildeten flexiblen Träger 30 umfaßt, der auf zwei einander abgewandten Oberflächen 28,29 jeweils mit Leiterbahnen 40a,40b versehen ist.

In eine solche flexible Leiterplatte kann noch eine Vielzahl weiterer Funktionen (neben der Übertragung von Signal- und/oder Leistungsstrom) integriert werden. Näheres hierzu wird nachfolgend anhand der Figuren 2a bis 4 beschrieben werden.

Zuvor sei noch darauf hingewiesen, daß die Verwendung einer flexiblen Leiterplatte besonders vorteilhaft ist bei einer geometrischen Anordnung von Stator, Rotor und Leiterplatte, bei der die flexible Leiterplatte 3 einen U-förmigen Abschnitt 3a aufweist, an dem sich die Erstreckungsrichtung der flexiblen Leiterplatte 3 bezüglich des Uhrzeigersinns umkehrt. Durch eine solche geometrische Anordnung wird die erforderliche Länge der flexiblen Leiterplatte 3 minimiert.

Diese Anordnung der flexiblen Leiterplatte wird vorliegend dadurch ermöglicht, daß in der inneren Kammer 13 der Anordnung ein Führungsring 18 für die flexible Leiterplatte 3 vorgesehen ist, der einen im wesentlichen U-förmigen Durchgang 19 zur Aufnahme und zum Abstützen des U-förmigen Abschnitts 3a der flexiblen Leiterplatte 3 aufweist. Durch den Führungsring 18 werden in der inneren Kammer 13 eine Aufnahme 13a für den auf die Wickelfläche 21 aufgewickelten Teil der flexiblen Leiterplatte 3 und eine weitere Aufnahme 13b für den von der Wickelfläche 21 abgewickelten Teil der Leiterplatte 3 gebildet.

Nähere Einzelheiten zu einer zweckmäßigen geometrischen Ausbildung von Stator 1, Rotor 2 und einer zwischen diesen beiden Bauelementen verlaufenden flexiblen Leitung im Hinblick auf eine Minimierung der Länge dieser Leitung können der EP 0 556 779 A1, der DE 195 06 865 C1 und der DE 197 34 527 A1 entnommen werden.

Fig. 2a zeigt eine Draufsicht auf eine weitere vorteilhafte Ausführungsform einer Einrichtung zur Übertragung elektrischen Stroms zwischen zwei zueinander verdrehbaren Bauelementen einer Lenkeinrichtung für Kraftfahrzeuge mit einem Stator 1 und einem Rotor 2. Der grundsätzliche Aufbau gleicht weitgehend der in den Figuren 1a und 1b beschriebenen Einrichtung, so daß für gleiche Bauelemente gleiche Bezugszeichen verwendet werden.

Der wesentliche Unterschied zur vorherigen Ausführungsform liegt darin, daß das Wickelelement für die flexible Leiterplatte 3 nicht wie in Fig. 1a als fest mit dem Stator verbundener Führungsring, sondern als bewegliches Wickelsegment 23 ausgeführt ist. Dieses Wickelsegment 23 ist in der Kammer 13 zwischen der Wickelfläche 21 des Rotors 2 und der Zwischenwand 11 des Stators 1 kreisringförmig ausgebildet. Es weist einen Durchgang 19 für den U-förmigen Umkehrabschnitt 3a der flexiblen Leiterplatte 3 auf. Das Wickelsegment 23 ist in der Kammer 13 frei drehbar angeordnet, so daß bei einer Drehung des Rotors 2 die sich auf- oder abwickelnde flexible Leiterplatte 3 das Wickelsegment 23 in Drehsinn des Rotors mitbewegt.

In Fig. 2b ist die Einrichtung gemäß der in Fig. 2a in Richtung IIb orientierten Teilansicht dargestellt. Das Wickelsegment 23 weist auf seinem Umfang in regelmäßigen Abständen in axialer und radialer Richtung erstreckte Zentrierungen auf. Diese erstrecken sich radial zwischen der flexiblen Leiterplatte 3 in der Aufnahme 13a und der Aufnahme 13b und axial zwischen der Basisfläche 20 des Rotors 2 und der Basisfläche 10 des Stators 1. Die Enden der Zentrierungen sind jeweils kugelförmig ausgebildet, so daß die Reibung zwischen Wickelsegment 23 und Basisfläche-20 des Rotors 2, Basisfläche 10 des Stators 1 bzw. flexibler Leiterplatte 3 reduziert wird. Weiterhin ist das Wickelsegment 23 in axialer Richtung leicht bogenförmig geformt, so daß es mit axialer Vorspannung in der Kammer 13 montiert wird. Dadurch ist beim Auf- und Abwickeln der flexiblen Leiterplatte 3 ein geräuscharmer und spielfreier axialer Lauf gewährleistet.

In Fig. 2c ist die Einrichtung in einem Schnitt entlang der Linie IIc-IIc gemäß Fig. 2a dargestellt. In Hinblick auf Fig. 1a sind wiederum gleiche Bauelemente mit gleichen Bezugszeichen versehen. Die Basisplatte 10 des Stators und die Basisfläche 20 des Rotors 2 weisen im Bereich der Kammer 13 zur Kammer 13 hin orientierte Auswölbungen 10a,20a auf. Bei einer Drehung des Rotors 2 berührt der u-förmige Abschnitt 3a der flexiblen Leiterplatte 3 den Stator 1 und den Rotor 2 ausschließlich in den Scheitelbereichen der beiden Wölbungen 10a, 20a, so daß die Reibungskräfte zwischen flexibler Leiterplatte 3 und Stator 1 bzw. Rotor 2 reduziert werden.

Fig. 3a zeigt in einer Draufsicht eine flexible Leiterplatte 3, auf deren längserstreckter Trägerfolie 30 nebeneinander eine Vielzahl von Leiterbahnen 40a verlaufen. Diese Leiterbahnen 40a wurden beispielsweise durch selektives Ätzen einer Kupferschicht erzeugt, die zuvor mit einer üblichen Methode der Leiterplattentechnik auf Vorder- und Rückseite der flexiblen Trägerfolie 30 aufgebracht worden war.

Der längserstreckte mittlere Abschnitt 31 der flexiblen Leiterplatte 3 ist aufgrund der Flexibiliät der Trägerfolie 30 wicklungsfähig, so daß die flexible Leiterplatte 3 in einer Einrichtung zur Übertragung elektrischen Stroms gemäß Fig. 1a verwendet werden kann.

An ihrem statorseitigen Ende 32 weist die Leiterplatte 3 eine Verstärkung 36 in Form eines Kunststoffelementes auf und ist ferner mit elektrischen Kontaktelementen 42 versehen, die mit entsprechenden elektrischen Anschlüssen des Stators 1 in Kontakt gebracht werden können.

Am rotorseitigen Ende 33 weist die Leiterplatte 3 eine weitere Verstärkung 36 mit einem Aufnahmeabschnitt 46 auf. Die Verstärkungen 36 umfassen ferner eine Mehrzahl von Öffnungen 39, durch die hindurch die Leiterplatte 3 abgestützt werden kann.

Aus dem Aufnahmeabschnitt 46 führen elektrische Leitungen 49 zum einen zum Steckverbinder 47, der Multifunktionsschalter kontaktiert, die im Lenkrad angeordnet sind. Solche Schalter können beispielsweise zur Bedienung der Scheibenwischer, einer Lenkradbeheizungseinrichtung und/oder eines Radios dienen. Weitere elektrische Leitungen 49 führen zum Steckverbinder 48, der die Zündvorrichtung des Gasgenerators einer in dem Lenkrad vorgesehenen Airbageinheit mit der Bordelektronik kontaktiert.

Eine zweite Ausführungsform einer flexiblen Leiterplatte ist in Fig. 3b dargestellt. Im Bereich der elektrischen Steckverbinder 47,48 und im Bereich zwischen den beiden Verstärkungen 31 ist diese Leiterplatte 3 identisch mit der in Fig. 3a gezeigten, wobei für identische Bauelemente jeweils auch identische Bezugszeichen verwendet werden. Diesbezüglich sei daher auf die Erläuterungen zu Fig. 3a verwiesen.

Die Leiterplatte 3 gemäß Fig. 3b unterscheidet sich von der Leiterplatte gemäß Fig. 3a dadurch, daß die Verstärkungen 36 aus drei im wesentlichen gleichgroßen, plättchenförmigen Verstärkungselementen bestehen. Diese Verstärkungselemente sind bündig zusammengefügt, wobei sie die, zwei Trägerfolien 30 aufweisende, flexible Leiterplatte 3 und die elektrischen Leiter 49 umschließen.

In Fig. 3c ist die Verstärkung 36 im Querschnitt entlang der Line IIIc-IIIc gemäß Figur 3b dargestellt. Das mittlere Verstärkungselement 36b weist in den beiden mit den äußeren Verstärkungselementen 36a und 36c gefügten Oberflächen eine Aussparung auf, in die sich jeweils ein stator- oder rotorseitiges Ende einer flexiblen Trägerfolie 30 einpassen läßt, so daß sich die äußeren Verstärkungselemente 36b und 36d formschlüssig an das mittlere Verstärkungselement 36b mit den eingelegten Trägerfolien 30 anfügen lassen.

In Figur 3d sind die drei Verstärkungselemente 36a-c voneinander getrennt in einer Draufsicht ihrer Fügeflächen gezeigt. Es ist zu erkennen, daß das mittlere Verstärkungselement 36b in einem Aufnahmeabschnitt 46 senkrecht zur Erstreckungsrichtung der Trägerfolie verlaufende Führungsaussparungen 36d aufweist, in die sich die elektrischen Leiter 49 einpassen lassen, wobei die äußeren Verstärkungselemente 36a und 36c spiegelbildlich zur jeweiligen Fügungsebene ebenfalls Führungsaussparungen 36d aufweisen, so daß die Leiter 49 beim bündigen Zusammenfügen der Verstärkungselemente 36a-c mit diesen kraftschlüssig verbunden sind. Hierdurch wird sichergestellt, daß die elektrische Kontaktierung zwischen den Leitern 49 und den Leiterbahnen 40a,40b auf der flexiblen Leiterplatte 3 zugentlastet sind.

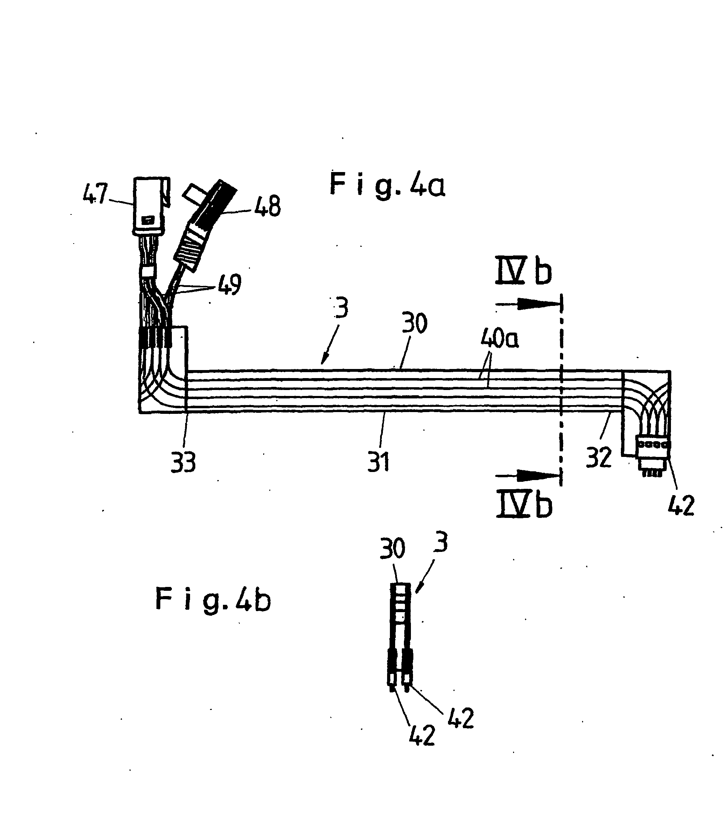

Eine weitere Ausführungsform der flexiblen Leiterplatte 3 ist in Fig. 4a dargestellt. Dabei ist das statorseitige Ende der Leiterplatte 3 breiter ausgeformt, so daß die Leiterbahnen 40a,40b der einander abgewandten Oberflächen 28,29 in unterschiedlichen nebeneinander angeordneten Bereiche enden. Dadurch läßt sich an die Leiterbahnen 40a und die Leiterbahnen 40b jeweils ein elektrisches Kontaktelement 42 anschlagen, ohne daß dabei die Gefahr besteht, Leiterbahnen 40a und 40b der einander abgewandten Oberflächen 28,29 der Leiterplatte 3 kurzzuschließen.

Fig. 4a zeigt, daß das breiter ausgebildete statorseitige Ende derart gefaltet ist, daß die elektrischen Kontaktelemente 42 quer zur Erstreckungsrichtung der Leiterplatte 3 hintereinander zum Liegen kommen. In Fig. 4b ist ein Querschnitt der flexiblen Leiterplatte 3 entlang der Line IVb-IVb gemäß Fig. 4a dargestellt. In einer Draufsicht zeigt diese Figur, daß die jeweiligen Kontaktelemente 42 der Leiterbahnen 40a und 40b nach dem Falten des statorseitigen Endes der flexiblen Leiterplatte 3 quer zu dessen Erstreckungsrichtung hintereinander angeordnet sind.

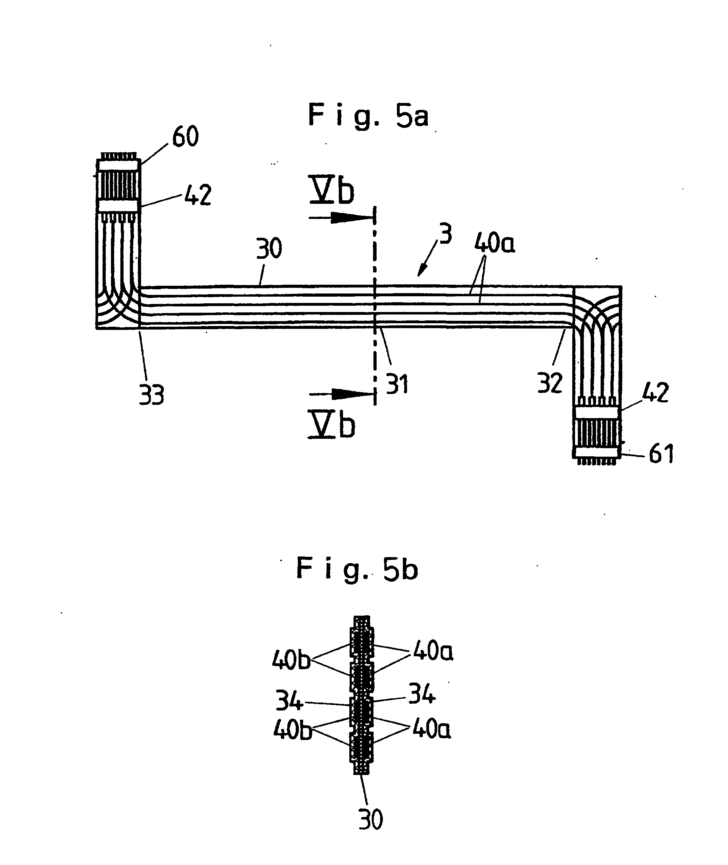

Fig. 5a zeigt eine weitere Ausführungsform der flexiblen Leiterplatte 3, die an ihrem rotor- und statorseitigen Ende 32,33 neben elektrischen Kontaktelementen 42 jeweils integrierte Schaltkreise 60,61 aufweist, die den elektrischen Kontaktelementen 42 zugeordnet sind.

In Fig.5b ist ein vergrößerter Querschnitt der flexiblen Leiterplatte 3 in deren mittleren Bereich 31 entlang der Linie Vb-Vb gemäß Fig. 5a dargestellt. Der in Fig. 5b erkennbare Aufbau der flexiblen Leiterplatte 3 entspricht im wesentlichen dem der Fig. 1c. Daher sei hier auf die entsprechenden Ausführungen zur Fig. 1c verwiesen.

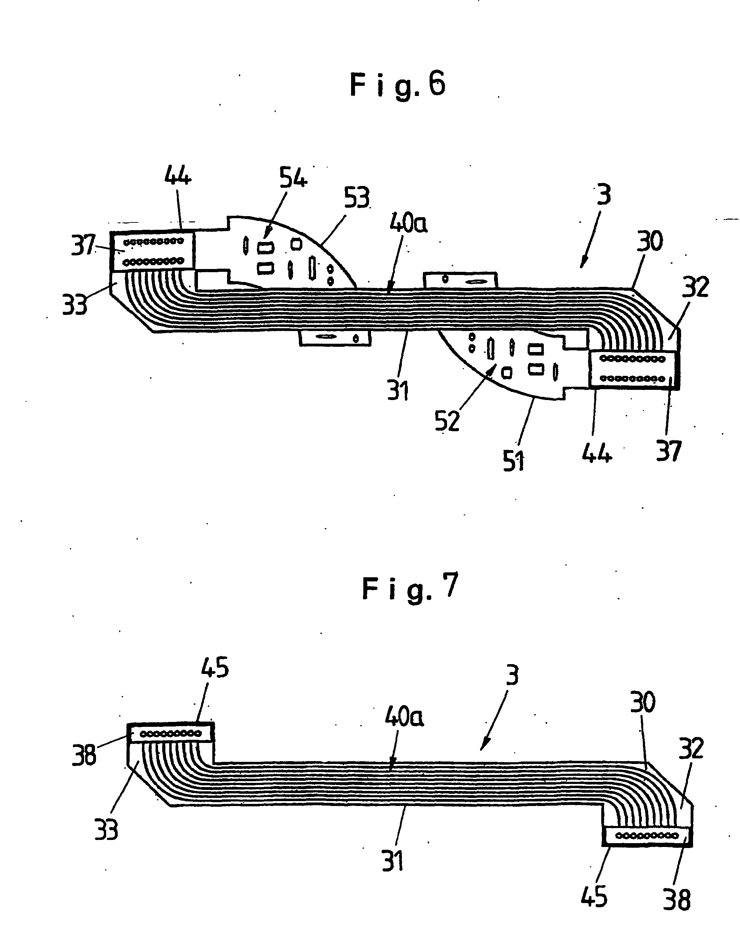

In Fig. 6 ist schematisch eine weitere Ausführungsform einer Leiterplatte 3 dargestellt, auf deren flexibler Trägerfolie 30 eine Mehrzahl von Leiterbahnen 40a und 40b auf Vorder- und Rückseite nebeneinanderliegend verläuft. In dem längserstreckten, wicklungsfähigen mittleren Abschnitt 31 der flexiblen Leiterplatte 3 verlaufen dabei die Leiterbahnen 40a und 40b in einem sehr geringen Abstand nebeneinander. Hierdurch kann die Trägerfolie 30 in diesem Abschnitt 31 der Leiterplatte 3 besonders schmal ausgelegt werden.

Sowohl zu dem statorseitigen Ende 32 als auch zu dem rotorseitigen Ende 33 hin vergrößern sich jedoch die Abstände zwischen den einzelnen Leiterbahnen 40a bzw. 40b, so daß die Trägerfolie 30 in diesen Abschnitten 32, 33 entsprechend breiter ausgelegt sein muß. Die Vergrößerung der Abstände zwischen den nebeneinander verlaufenden Leiterbahnen 40a bzw. 40b im Bereich der Endabschnitte 32, 33 erleichtert die Kontaktierung der Leiterbahnen 40a und 40b über geeignete Steckerelemente 44. Zusätzlich ist im Bereich der Steckerelemente 44 jeweils noch ein aus Kunststoff bestehendes Verstärkungselement 37 vorgesehen, um eine hinreichende Stabilität der flexiblen Leiterplatte 3 im Bereich der Steckerelemente 44 zu gewährleisten.

Die flexible Leiterplatte 3 weist sowohl im Bereich ihres statorseitigen Endes 32 als auch im Bereich ihres rotorseitigen Endes 33 jeweils einen Fortsatz 51 bzw. 53 auf, auf dem weitere elektrische Bauelemente angeordnet sind.

Der statorseitige Fortsatz 51 dient dabei der Aufnahme eines Lenkwinkelsensors und ist daher mit den elektrischen Bauelementen einer elektronischen Auswerteinheit 52 dieses Lenkwinkelsensors versehen. Außerdem kann die statorseitige elektronische Baugruppe 52 der flexiblen Leiterplatte 3 auch die Elektronik des Blinkerschalters 56 aus Fig. 1b umfassen.

Auf dem rotorseitigen Fortsatz 53 der Leiterplatte 3 angeordnete elektronische Baugruppen 54 können insbesondere als elektronische Steuerung für die Zündeinrichtung einer Airbageinheit oder für im Bereich des Lenkrades angeordnete Multifunktionsschalter dienen. Ferner können mittels der elektronischen Baugruppen 52, 54 auch Signale codiert bzw. decodiert werden.

Anhand dieses Ausführungsbeispiels wird besonders deutlich, daß nach der erfindungsgemäßen Lösung die flexible Leiterplatte 3 neben der Übertragung von Signal- und/oder Leistungsstrom vom Stator zum Rotor einer Lenkeinrichtung noch eine Vielzahl weiterer Funktionen übernehmen kann. Hierdurch wird der Integrationsgrad der elektrischen und elektronischen Baugruppen im Bereich der Lenkeinrichtung erhöht. Somit können sowohl die Kosten bei der Herstellung dieser elektronischen Baugruppen als auch deren Platzbedarf minimiert werden.

Eine weitere Ausführungsform einer flexiblen Leiterplatte ist in Fig. 7 dargestellt. In dem Bereich zwischen den beiden Steckerelementen 45 ist diese Leiterplatte 3 identisch mit der in Fig. 6 gezeigten, wobei für identische Bauelemente jeweils auch identische Bezugszeichen verwendet werden. Diesbezüglich sei daher auf die Erläuterungen zu Fig. 6 verwiesen.

Die Leiterplatte 3 gemäß Fig. 7 unterscheidet sich von der Leiterplatte gemäß Fig. 6 zum einen dadurch, daß die beiden Steckerelemente 45 und die zugehörigen Verstärkungselemente 38 am statorseitigen Ende 32 bzw. am rotorseitigen Ende 33 der Leiterplatte 3 schmaler ausgebildet sind.

Darüber hinaus weist die Leiterplatte 3 aus Fig. 7 an ihren Enden keine Fortsätze zur Aufnahme weiterer elektronischer Baugruppen auf. Die Funktion dieser flexiblen Leiterplatte 3 beschränkt sich somit auf die Übertragung von Signal- und/oder Leistungsstrom zwischen Stator und Rotor.

Auch diese flexible Leiterplatte 3 hat gegenüber den herkömmlichen elektrischen Leitungen, die zur Verbindung von Stator und Rotor vorgesehen sind, den wesentlichen Vorteil, daß der Platzbedarf minimiert werden kann. Denn wie schon anhand der Fig. 6 erläutert, ermöglicht die freie beidseitige Gestaltbarkeit der flexiblen Leiterplatte 3 deren besonders schmale Auslegung in ihren mittleren Abschnitt 31, der ja gemäß Fig. 1b zwischen dem Stator und dem Rotor der Lenkeinrichtung verläuft. Lediglich an ihren beiden Endabschnitten 32, 33 wird die Leiterplatte 3 gezielt verbreitert, um dort die Kontaktierung der Leiterbahnen 40a und 40b über Steckerelemente 45 zu ermöglichen.

## Patentansprüche

1. Einrichtung zur Übertragung elektrischen Stroms zwischen zwei zueinander verdrehbaren Bauelementen einer Lenkeinrichtung für Kraftfahrzeuge mit
- einem Rotor (2), der dem Lenkrad zugeordnet und gemeinsam mit diesem drehbar ist,
- einem Stator (1), der einer stationären Baugruppe des Fahrzeugs zugeordnet ist, und
- mindestens einer flexiblen Leiterplatte (3), die vom Rotor (2) zum Stator (1) verläuft und beim Drehen des Lenkrades je nach Drehrichtung auf ein Wickelelement (18,23) aufwickelbar oder von diesem abwickelbar ist und die einen flach ausgebildeten flexiblen Träger (30) umfaßt, auf dem Leiterbahnen (40a,40b) vom Stator (1) zum Rotor (2) verlaufen,
**dadurch gekennzeichnet,**
**daß** der flexible Träger (30) auf zwei einander abgewandten Oberflächen (28,29) jeweils Leiterbahnen (40a,40b) aufweist, die vom Stator (1) zum Rotor (2) verlaufen,
**daß** in die flexible Leiterplatte (3), insbesondere an einem ihrer Enden, mindestens eine elektronische Baugruppe (52,54) zur Codierung und/oder Decodierung von mittels der flexiblen Leiterplatte (3) zu übertragen den Signalen integriert ist.

2. Vorrichtung nach Anspruch 1, **dadurch gekennzeichnet, daß** der flexible Träger (30) bandartig ausgebildet ist und beidseitig Leiterbahnen (40a,40b) aufweist.

3. Einrichtung nach Anspruch 1 oder 2, **dadurch gekennzeichnet, daß** der Träger (30) als Folie ausgebildet ist und daß die Leiterbahnen (40a,40b) als Metalldünnschichten ausgebildet sind.

4. Einrichtung nach Anspruch 3, **dadurch gekennzeichnet, daß** die Leiterbahnen (40a,40b) entlang der Erstreckungsrichtung zwischen stator- und rotorseitigem Ende (32, 33) der Folie verlaufen.

5. Einrichtung nach einem der vorhergehenden Ansprüche, **dadurch gekennzeichnet, daß** auf dem flexiblen Träger (30) Leiterbahnen (40a,40b) unterschiedlichen Querschnitts verlaufen.

6. Einrichtung nach einem der vorhergehenden Ansprüche, **dadurch gekennzeichnet, daß** der flexiblen Leiterplatte (3) jeweils mindestens ein elektrischer Anschluß an einem Stator (1) und an einem Rotor (2) zugeordnet ist und daß die flexible Leiterplatte (3) an ihrem stator-und ihrem rotorseitigen Ende (32,33) jeweils elektrische Kontaktelemente (42-45, 47, 48) aufweist, die mit den Anschlüssen in Kontakt bringbar sind.

7. Einrichtung nach Anspruch 6, **dadurch gekennzeichnet, daß** die Kontaktelemente (42-45, 47, 48) als Steckerelemente ausgebildet sind, die in die elektrischen Anschlüsse des Stators (1) bzw. des Rotors (2) einsteckbar sind.

8. Einrichtung nach Anspruch 6 oder 7, **dadurch gekennzeichnet, daß** die Kontaktelemente (42-45, 47, 48) zur Kontaktierung von im wesentlichen quer zur Ersteckungsrichtung zwischen stator- und rotorseitigem Ende (32, 33) der flexiblen Leiterplatte (3) angeordneten elektrischen Anschlüssen vorgesehen sind.

9. Einrichtung nach Anspruch 6 oder 7, **dadurch gekennzeichnet, daß** die Kontaktelemente (42-45, 47, 48) zur Kontaktierung von im wesentlichen parallel zur Erstreckungsrichtung zwischen stator- und rotorseitigem Ende (32, 33) der flexiblen Leiterplatte (3) angeordneten elektrischen Anschlüssen vorgesehen sind.

10. Einrichtung nach einem der vorhergehenden Ansprüche, **dadurch gekennzeichnet, daß** die Leiterbahnen (40a,40b) auf dem flexiblen Träger (30) nebeneinander verlaufen und daß der Abstand zwischen den einzelnen Leiterbahnen (40a,40b) im Bereich des stator- und/oder des rotorseitigen Endes (32,33) der Leiterplatte (3) zunimmt.

11. Einrichtung nach einem der vorhergehenden Ansprüche, **dadurch gekennzeichnet, daß** die flexible Leiterplatte (3) an ihrem stator- und/oder rotorseitigen Ende (32,33), insbesondere im Bereich der elektrischen Kontaktelemente (42-45, 47, 48), zur Stabilisierung eine Verstärkung (36-38) aufweist.

12. Einrichtung nach Anspruch 11, **dadurch gekennzeichnet, daß** die Verstärkung (36-38) durch mindestens ein Kunststoffelement gebildet wird, das auf die flexible Leiterplatte (3) aufgespritzt oder aufgeclipst ist.

13. Einrichtung nach Anspruch 11 oder 12, **dadurch gekennzeichnet, daß** Leitungen (49) vorgesehen sind, die von den Kontaktelementen (42-45, 47, 48) zu den Leiterbahnen (40a,40b) verlaufen, und daß Mittel vorgesehen sind, um Zugkräfte, die an den Leitungen (49) angreifen, in einen Aufnahmeabschnitt (46) für die Leitungen abzuleiten, mittels dem die Leitungen (49) zu den Leiterbahnen (40a,40b) geführt sind.

14. Einrichtung nach Anspruch 13, **dadurch gekennzeichnet, daß** der Aufnahmeabschnitt (46) für die Leitungen (49) als Teil der Verstärkung (36) ausgebildet ist.

15. Einrichtung nach Anspruch 13 oder 14, **dadurch gekennzeichnet, daß** der Aufnahmeabschnitt (46) eine Mehrzahl von Führungsaussparungen (36d) aufweist, in denen die Leitungen kraftschlüssig gehalten sind.

16. Einrichtung nach Anspruch 15, **dadurch gekennzeichnet, daß** die Führungsaussparungen (36d) im wesentlichen senkrecht zur Erstreckungsrichtung zwischen stator- und rotorseitigem Ende (32, 33) der flexiblen Leiterplatte (3) verlaufen.

17. Einrichtung nach Anspruch 15, **dadurch gekennzeichnet, daß** die Führungsaussparungen (36d) im wesentlichen parallel zur Erstreckungsrichtung zwischen stator- und rotorseitigem Ende (32, 33) der flexiblen Leiterplatte (3) verlaufen.

18. Einrichtung nach einem der Ansprüche 11 bis 17, **dadurch gekennzeichnet, daß** die Verstärkung (36) mindestens zwei Verstärkungselemente umfaßt, die eine flexible Leiterplatte (3) zwischen sich aufnehmen.

19. Einrichtung nach Anspruch 18, **dadurch gekennzeichnet, daß** die Verstärkung zum Einbringen oder Entnehmen einer flexiblen Leiterplatte aufklappbar ist.

20. Einrichtung nach Anspruch 19, **dadurch gekennzeichnet, daß** die Verstärkungselemente zur Klappverbindung ein Filmscharnier aufweisen.

21. Einrichtung nach einem der Ansprüche 18 bis 20 **dadurch gekennzeichnet, daß** die Verstärkung (36) aus drei Verstärkungselementen (36a,36b,36c) besteht.

22. Einrichtung nach einem der vorangehenden Ansprüche, **dadurch gekennzeichnet, daß** den Leiterbahnen (40a,40b) auf jeder der beiden Oberflächen (28,29) des flexiblen Trägers (30) an dem rotor- und/oder statorseitigen Ende der flexiblen Leiterplatte (3) jeweils ein separates elektrisches Kontaktelement (42-45, 47, 48) zugeordnet ist.

23. Einrichtung nach Anspruch 22, **dadurch gekennzeichnet, daß** die elektrischen Kontaktelemente (42-45, 47, 48) an dem rotor- und/oder statorseitigen Ende der flexiblen Leiterplatte (3) auf dem flexible Träger (30) angeordnet sind und daß der flexible Träger (30) an dem jeweiligen Ende derart gefaltet ist, daß die elektrischen Kontaktelemente (42-45, 47, 48) quer zur Erstreckungsrichtung zwischen stator- und rotorseitigem Ende (32,33) der flexiblen Leiterplatte (3) hintereinander angeordnet sind.

24. Einrichtung nach einem der vorhergehenden Ansprüche, **dadurch gekennzeichnet, daß** die flexible Leiterplatte (3) an ihren Enden (32,33) mit dem Stator (1) und/oder dem Rotor (2) über Rastelemente verbunden ist.

25. Einrichtung nach einem der Ansprüche 1 bis 23, **dadurch gekennzeichnet, daß** die flexible Leiterplatte (3) an ihren Enden (32,33) mit dem Stator (1) und/oder dem Rotor (2) verklebt ist.

26. Einrichtung nach einem der vorhergehenden Ansprüche, **dadurch gekennzeichnet, daß** am statorseitigen Ende (32) der flexiblen Leiterplatte (3) ein Lenkwinkelsensor vorgesehen ist.

27. Einrichtung nach Anspruch 26, **dadurch gekennzeichnet, daß** eine dem Lenkwinkelsensor zugeordnete elektronische Auswerteinheit (52) in die flexible Leiterplatte (3) integriert ist.

28. Einrichtung nach einem der vorhergehenden Ansprüche, **dadurch gekennzeichnet, daß** eine elektronische Baugruppe zur Steuerung einer, Lenkradheizung in die flexible Leiterplatte (3) integriert ist.

29. Einrichtung nach einem der vorhergehenden Ansprüche, **dadurch gekennzeichnet, daß** in das rotorseitige Ende (33) der flexiblen Leiterplatte (3) eine Elektronikeinheit (54) integriert ist, die mit lenkradseitigen elektrischen Bauelementen gekoppelt ist.

30. Einrichtung nach einem der vorhergehenden Ansprüche, **dadurch gekennzeichnet, daß** die flexible Leiterplatte (3) an ihrem rotor- und/oder statorseitigen Ende integrierte Schaltkreise (60,61), zum Codieren und/oder Decodieren zu übertragender Signale aufweist.

31. Einrichtung nach einem der vorhergehenden Ansprüche, **dadurch gekennzeichnet, daß** der Stator (1) und der Rotor (2) ein inneres und ein äußeres Gehäuseelement bilden, die gegeneinander verdrehbar sind, wobei vorzugsweise der Stator (1) den Rotor (2) ringartig umgibt und das Wickelelement (21) für die flexible Leiterplatte (3) Bestandteil des Rotors (2) ist.

32. Einrichtung nach einem der vorhergehenden Ansprüche, **dadurch gekennzeichnet, daß** die flexible Leiterplatte (3) mindestens einen Abschnitt (3a) aufweist, entlang dem sich die Erstreckungerichtung zwischen stator- und rotorseitigem Ende (32,33) der flexiblen Leiterplatte (3) bezüglich des Umfangs (U) der Anordnung umkehrt.

33. Einrichtung nach Anspruch 32, **dadurch gekennzeichnet, daß** zwischen dem Stator (1) und dem Rotor (2) eine Führung (18) für die flexible Leiterplatte (3) vorgesehen ist, die sich vorzugsweise als Ringführung zwischen Stator (1) und Rotor (2) erstreckt.

34. Einrichtung nach Anspruch 33, **dadurch gekennzeichnet, daß** durch die Führung (18) zwischen dem Stator (1) und dem Rotor (2) eine erste Aufnahme (13a) für den aufgewickelten Teil der flexiblen Leiterplatte (3) und eine zweite Aufnahme (13b) für den abgewickelten Teil der flexiblen Leiterplatte (3) gebildet werden.

35. Einrichtung nach einem der vorhergehenden Ansprüche, **dadurch gekennzeichnet, daß** der Stator (1) zur Aufnahme mindestens eines Bedienschalters (56) vorgesehen ist, dem eine elektronische Baugruppe auf der flexiblen Leiterplatte zugeordnet ist.

## Claims

1. Device for transmitting electric current between two components, which can rotate with respect to one another, of a steering device for motor vehicles, having
- a rotor (2), which is associated with the steering wheel and can rotate together with it,
- a stator (1), which is associated with the stationary assembly in the motor vehicle, and
- at least one flexible printed circuit (3), which runs from the rotor (2) to the stator (1) and can be wound up onto a winding element (18, 23), or can be unwound from this winding element (18, 23), during rotation of the steering wheel, depending on its rotation direction, and which has a flat flexible substrate (30), on which conductor tracks (40a, 40b) run from the stator (1) to the rotor (2),
**characterized**
**in that** the flexible substrate (30) has conductor tracks (40a, 40b), which run from the stator (1) to the rotor (2), on each of two surfaces (28, 29) which face away from one another,
**in that** at least one electronic assembly (52, 54) for coding or decoding signals to be transmitted by means of the flexible printed circuit (3) is integrated in the flexible printed circuit (3), in particular at one of its ends.

2. Apparatus according to Claim 1, **characterized in that** the flexible substrate (30) is in the form of a strip and has conductor tracks (40a, 40b) on both sides.

3. Device according to Claim 1 or 2, **characterized in that** the substrate (30) is in the form of a film, and **in that** the conductor tracks (40a, 40b) are in the form of thin metal layers.

4. Device according to Claim 3, **characterized in that** the conductor tracks (40a, 40b) run along the direction in which the film extends between the stator end (3) and the rotor end (33).

5. Device according to one of the preceding claims, **characterized in that** conductor tracks (40a, 40b) with different cross sections run on the flexible substrate (30).

6. Device according to one of the preceding claims, **characterized in that** the flexible printed circuit (3) has in each case at least one associated electrical connection on a stator (1) and on a rotor (2), and **in that** the flexible printed circuit (3) has electrical contact elements (42-45, 47, 48) which can make contact with the connections, at both its stator end (32) and its rotor end (33).

7. Device according to Claim 6, **characterized in that** the contact elements (42-45, 47, 48) are in the form of plug elements, which can be inserted into the electrical connections of the stator (1) and of the rotor (2), respectively.

8. Device according to Claim 6 or 7, **characterized in that** the contact elements (42-45, 47, 48) are intended for making contact with electrical connections which are arranged essentially transversely with respect to the direction in which the flexible printed circuit (3) extends between the stator end (3) and the rotor end (33).

9. Device according to Claim 6 or 7, **characterized in that** the contact elements (42-45, 47, 48) are intended for making contact with electrical connections which are arranged essentially parallel to the direction in which the flexible printed circuit (3) extends between the stator end (3) and the rotor end (33).

10. Device according to one of the preceding claims, **characterized in that** the conductor tracks (40a, 40b) run alongside one another on the flexible substrate (30), and **in that** the distance between the individual conductor tracks (40a, 40b) increases in the region of the stator end (32) and/or of the rotor end (33) of the printed circuit (3).

11. Device according to one of the preceding claims, **characterized in that** the flexible printed circuit (3) has a reinforced region (36-38) at its stator end (32) and/or at its rotor end (33), in particular in the region of the electrical contact elements (42-45, 47, 48), in order to give it robustness.

12. Device according to Claim 11, **characterized in that** the reinforced region (36-38) is formed by at least one plastic element, which is moulded or clipped onto the flexible printed circuit (3).

13. Device according to Claim 11 or 12, **characterized in that** lines (49) are provided, which run from the contact elements (42-45, 47, 48) to the conductor tracks (40a, 40b), and **in that** means are provided in order to divert tensile forces, which act on the lines (49), into a holding section (46) for the lines, by means of which the lines (49) are connected to the conductor tracks (40a, 40b).

14. Device according to Claim 13, **characterized in that** the holding section (46) for the lines (49) is part of the reinforced region (36).

15. Device according to Claim 13 or 14, **characterized in that** the holding section (46) has a number of guide cutouts (36d) in which the lines are held with a force fit.

16. Device according to Claim 15, **characterized in that** the guide cutouts (36d) run essentially at right angles to the direction in which the flexible printed circuit (3) extends between the stator end (3) and the rotor end (33).

17. Device according to Claim 15, **characterized in that** the guide cutouts (36d) run essentially parallel to the direction in which the flexible printed circuit (3) extends between the stator end (3) and the rotor end (33).

18. Device according to one of Claims 11 to 17, **characterized in that** the reinforced region (36) has at least two reinforcing elements, which hold a flexible printed circuit (3) between them.

19. Device according to Claim 18, **characterized in that** the reinforced region can be folded up in order to fit or remove a flexible printed circuit.

20. Device according to Claim 19, **characterized in that** the reinforcing elements have a film hinge for the folding connection.

21. Device according to one of Claims 18 to 20, **characterized in that** the reinforced region (36) comprises three reinforcing elements (36a, 36b, 36c).

22. Device according to one of the preceding claims, **characterized in that** the conductor tracks (40a, 40b) each have a separate associated electrical contact element (42-45, 47, 48) at the rotor end and/or at the stator end of the flexible printed circuit (3), on each of the two surfaces (28, 29) of the flexible substrate (3).

23. Device according to Claim 22, **characterized in that** the electrical contact elements (42-45, 47, 48) are arranged on the flexible substrate (30) at the rotor end and/or at the stator end of the flexible printed circuit (3), and **in that** the flexible substrate (30) is folded at the respective end such that the electrical contact elements (42-45, 47, 48) are arranged one behind the other, transversely to the direction in which the flexible printed circuit (3) extends between the stator end (3) and the rotor end (33).

24. Device according to one of the preceding claims, **characterized in that** the flexible printed circuit (3) is connected via latching elements at its ends (32, 33) to the stator (1) and/or to the rotor (2).

25. Device according to one of Claims 1 to 23, **characterized in that** the flexible printed circuit (3) is adhesively bonded to the stator (1) and/or to the rotor (2) at its ends (32, 33).

26. Device according to one of the preceding claims, **characterized in that** a steering angle sensor is provided at the stator end (32) of the flexible printed circuit (3).

27. Device according to Claim 26, **characterized in that** an electronic evaluation unit (52), which is associated with the steering angle sensor, is integrated in the flexible printed circuit (3).

28. Device according to one of the preceding claims, **characterized in that** an electronic assembly for controlling steering wheel heating is integrated in the flexible printed circuit (3).

29. Device according to one of the preceding claims, **characterized in that** an electronics unit (54), which is coupled to electrical components on the steering wheel side, is integrated in the rotor end (33) of the flexible printed circuit (3).

30. Device according to one of the preceding claims, **characterized in that**, at its rotor end and/or at its stator end, the flexible printed circuit (3) has integrated circuits (60, 61) for coding and/or decoding signals to be transmitted.

31. Device according to one of the preceding claims, **characterized in that** the stator (1) and the rotor (2) form an inner and an outer housing element, which can rotate with respect to one another, with the stator (1) preferably surrounding the rotor (2) in an annular shape, and the winding element (21) for the flexible printed circuit (3) being a component of the rotor (2).

32. Device according to one of the preceding claims, **characterized in that** the flexible printed circuit (3) has at least one section (3a) along which the direction in which the flexible printed circuit (3) extends between the stator end (3) and the rotor end (33) reverses with respect to the circumference (U) of the arrangement.

33. Device according to Claim 32, **characterized in that** a guide (18) for the flexible printed circuit (3) is provided between the stator (1) and the rotor (2), and extends, preferably as an annular guide, between the stator (1) and the rotor (2).

34. Device according to Claim 33, **characterized in that** the guide (18) between the stator (1) and the rotor (2) forms a first holder (13a) for the wound-up part of the flexible printed circuit (3), and a second holder (13b) for the unwound part of the flexible printed circuit (3).

35. Device according to one of the preceding claims, **characterized in that** the stator (1) is intended to hold at least one control switch (56), which is associated with an electronic assembly on the flexible printed circuit.

## Revendications

1. Dispositif pour transmettre un courant électrique entre deux composants rotatifs l'un par rapport à l'autre d'un mécanisme de direction pour véhicules automobiles, comportant
- un rotor (2) qui est associé au volant et qui est rotatif conjointement avec celui-ci,
- un stator (1) qui est associé à un groupe structurel stationnaire du véhicule, et
- au moins une carte flexible à circuits imprimés (3) qui s'étend depuis le rotor (2) vers le stator (1) et qui, lors de la rotation du volant, est susceptible d'être enroulée sur un élément d'enroulement (18, 23) ou d'être déroulée de celui-ci, en fonction du sens de rotation, et qui comprend un support flexible (30) réalisé à plat sur lequel s'étendent des pistes conductrices (40a, 40b) depuis le stator (1) vers le rotor (2),
**caractérisé en ce que**
le support flexible (30) comprend, sur deux surfaces (28, 29) détournées l'une de l'autre, des pistes conductrices respectives (40a, 40b) qui s'étendent depuis le stator (1) vers le rotor (2),
**en ce qu'**au moins un groupe structurel électronique (52, 54) destiné au codage et/ou au décodage de signaux à transmettre au moyen de la carte flexible à circuits imprimés (3) est intégré dans la carte flexible à circuits imprimés (3), en particulier à l'une de ses extrémités.

2. Dispositif selon la revendication 1, **caractérisé en ce que** le support flexible (30) est réalisé en forme de bande et comprend des deux côtés des pistes conductrices (40a, 40b).

3. Dispositif selon la revendication 1 ou 2, **caractérisé en ce que** le support (30) est réalisé sous forme de feuille et **en ce que** les pistes conductrices (40a, 40b) sont réalisées sous forme de couches métalliques minces.

4. Dispositif selon la revendication 3, **caractérisé en ce que** les pistes conductrices (40a, 40b) s'étendent le long de la direction d'extension de la feuille entre les extrémités (32, 33) côté stator et côté rotor.

5. Dispositif selon l'une des revendications précédentes, **caractérisé en ce que** sur le support flexible (30) s'étendent des pistes conductrices (40a, 40b) de différentes sections transversales.

6. Dispositif selon l'une des revendications précédentes, **caractérisé en ce qu'**à la carte flexible à circuits imprimés (3) est associé au moins un raccord électrique respectif vers un stator (1) et vers un rotor (2), et **en ce que** la carte flexible à circuits imprimés (3) comprend à ses extrémités (32, 33) côté stator et côté rotor des éléments respectifs de contact électrique (42 - 45, 47, 48) susceptibles d'être amenés en contact avec les raccords.

7. Dispositif selon la revendication 6, **caractérisé en ce que** les éléments de contact (42 - 45, 47, 48) sont réalisés sous forme d'éléments d'enfichage susceptibles d'être enfichés dans les raccords électriques du stator (1) ou du rotor (2).

8. Dispositif selon la revendication 6 ou 7, **caractérisé en ce que** les éléments de contact (42 - 45, 47, 48) sont prévus pour la mise en contact de raccords électriques agencés sensiblement transversalement à la direction d'extension entre les extrémités (32, 33) côté stator et côté rotor de la carte flexible à circuits imprimés (3).

9. Dispositif selon la revendication 6 ou 7, **caractérisé en ce que** les éléments de contact (42 - 45, 47, 48) sont prévus pour la mise en contact de raccords électriques agencés sensiblement parallèlement à la direction d'extension entre les extrémités (32, 33) côté stator et côté rotor de la carte flexible à circuits imprimés (3).

10. Dispositif selon l'une des revendications précédentes, **caractérisé en ce que** les pistes conductrices (40a, 40b) sur le support flexible (30) s'étendent les unes à côté des autres et **en ce que** la distance entre les pistes conductrices individuelles (40a, 40b) augmente dans la zone de l'extrémité (32, 33) côté stator et/ou côté rotor de la carte à circuits imprimés (3).

11. Dispositif selon l'une des revendications précédentes, **caractérisé en ce que** la carte flexible à circuits imprimés (3) comprend à son extrémité (32, 33) côté stator et/ou côté rotor, en particulier dans la zone des éléments de contact électrique (42 - 45, 47, 48), un renforcement (36 - 38) pour la stabilisation.

12. Dispositif selon la revendication 11, **caractérisé en ce que** le renforcement (36 - 38) est formé par au moins un élément en matière plastique qui est injecté ou clipsé sur la carte flexible à circuits imprimés (3).

13. Dispositif selon la revendication 11 ou 12, **caractérisé en ce qu'**il est prévu des lignes (49) qui s'étendent depuis les éléments de contact (42 - 45, 47, 48) vers les pistes conductrices (40a, 40b), et **en ce qu'**il est prévu des moyens pour évacuer des forces de traction, attaquant les lignes (49), vers une portion (46) de réception des lignes, au moyen de laquelle les lignes (49) sont menées vers les pistes conductrices (40a, 40b).

14. Dispositif selon la revendication 13, **caractérisé en ce que** la portion (46) de réception des lignes (49) est réalisée comme partie du renforcement (36).

15. Dispositif selon la revendication 13 ou 14, **caractérisé en ce que** la portion de réception (46) comprend une pluralité d'échancrures de guidage (36d) dans lesquelles les lignes sont retenues par coopération de forces.

16. Dispositif selon la revendication 15, **caractérisé en ce que** les échancrures de guidage (36d) s'étendent sensiblement perpendiculairement à la direction d'extension entre les extrémités (32, 33) côté stator et côté rotor de la carte flexible à circuits imprimés (3).

17. Dispositif selon la revendication 15, **caractérisé en ce que** les échancrures de guidage (36d) s'étendent sensiblement parallèlement à la direction d'extension entre les extrémités (32, 33) côté stator et côté rotor de la carte flexible à circuits imprimés (3).

18. Dispositif selon l'une des revendications 11 à 17, **caractérisé en ce que** le renforcement (36) comprend au moins deux éléments de renforcement qui reçoivent entre eux une carte flexible à circuits imprimés (3).

19. Dispositif selon la revendication 18, **caractérisé en ce que** le renforcement est rabattable pour introduire ou enlever une carte flexible à circuits imprimés.

20. Dispositif selon la revendication 19, **caractérisé en ce que** les éléments de renforcement comprennent une charnière en film pour la liaison rabattable.

21. Dispositif selon l'une des revendications 18 à 20, **caractérisé en ce que** le renforcement (36) est constitué par trois éléments de renforcement (36a, 36b, 36c).

22. Dispositif selon l'une des revendications précédentes, **caractérisé en ce qu'**aux pistes conductrices (40a, 40b) est associé, sur chacune des deux surfaces (28, 29) du support flexible (30), un élément de contact électrique séparé respectif (42 - 45, 47, 48) à l'extrémité côté rotor et/ou côté stator de la carte flexible à circuits imprimés (3).

23. Dispositif selon la revendication 22, **caractérisé en ce que** les éléments de contact électrique (42 - 45, 47, 48) sont agencés sur le support flexible (30) à l'extrémité côté rotor et/ou stator de la carte flexible à circuits imprimés (3), et **en ce qu'**à l'extrémité respective le support flexible (30) est plissé de telle sorte que les éléments de contact électrique (42 - 45, 47, 48) sont agencés les uns derrière les autres en direction d'extension entre les extrémités (32, 33) côté stator et côté rotor de la carte flexible à circuits imprimés (3).

24. Dispositif selon l'une des revendications précédentes, **caractérisé en ce qu'**à ses extrémités (32, 33) la carte flexible à circuits imprimés (3) est reliée au stator (1) et/ou au rotor (2) via des éléments d'enclenchement.

25. Dispositif selon l'une des revendications 1 à 23, **caractérisé en ce qu'**à ses extrémités (32, 33) la carte flexible à circuits imprimés (3) est collée sur le stator (1) et/ou sur le rotor (2).

26. Dispositif selon l'une des revendications précédentes, **caractérisé en ce qu'**il est prévu un détecteur d'angle de braquage à l'extrémité (32) côté stator de la carte flexible à circuits imprimés (3).

27. Dispositif selon la revendication 26, **caractérisé en ce qu'**une unité d'évaluation électronique (52) associée au détecteur d'angle de braquage est intégrée dans la carte flexible à circuits imprimés (3).

28. Dispositif selon l'une des revendications précédentes, **caractérisé en ce qu'**un groupe structurel électronique destiné à la commande d'un chauffage de volant est intégré dans la carte flexible à circuits imprimés (3).

29. Dispositif selon l'une des revendications précédentes, **caractérisé en ce qu'**une unité électronique (54) est intégrée dans l'extrémité (33) côté rotor de la carte flexible à circuits imprimés (3), unité qui est couplée aux composants électriques côté volant.

30. Dispositif selon l'une des revendications précédentes, **caractérisé en ce qu'**à son extrémité côté rotor et/ou côté stator la carte flexible à circuits imprimés (3) comprend des circuits intégrés (60, 61) destinés au codage et/ou au décodage de signaux à transmettre.

31. Dispositif selon l'une des revendications précédentes, **caractérisé en ce que** le stator (1) et le rotor (2) forment des éléments de boîtier intérieur et extérieur qui sont rotatifs l'un par rapport à l'autre, et de préférence le stator (1) entoure en forme annulaire le rotor (2) et l'élément d'enroulement (21) destiné à la carte flexible à circuits imprimés (3) fait partie du rotor (2).

32. Dispositif selon l'une des revendications précédentes, **caractérisé en ce que** la carte flexible à circuits imprimés (3) comprend au moins une portion (3a) le long de laquelle la direction d'extension entre les extrémités (32, 33) côté stator et côté rotor de la carte flexible à circuits imprimés (3) est inversée par rapport à la périphérie (U) de l'agencement.

33. Dispositif selon la revendication 32, **caractérisé en ce qu'**un guidage (18) destiné à la carte flexible à circuits imprimés (3) est prévu entre le stator (1) et le rotor (2) et s'étend de préférence sous forme de guidage annulaire entre le stator (1) et le rotor (2).

34. Dispositif selon la revendication 33, **caractérisé en ce qu'**un premier logement (13a) pour la partie enroulée de la carte flexible à circuits imprimés (3) et un second logement (13b) pour la partie déroulée de la carte flexible à circuits imprimés (3) sont formés par le guidage (18) entre le stator (1) et le rotor (2).

35. Dispositif selon l'une des revendications précédentes, **caractérisé en ce que** le stator (1) est prévu pour recevoir au moins un commutateur de manipulation (56) auquel est associé un groupe structurel électronique sur la carte flexible à circuits imprimés.
